Europäisches Patentamt

European Patent Office

Office européen des brevets

(11) Veröffentlichungsnummer: **0 403 985**

**A1**

## (12) EUROPÄISCHE PATENTANMELDUNG

(21) Anmeldenummer: **90111377.9**

(22) Anmeldetag: **16.06.90**

(51) Int. Cl.5: **H01J 37/32, B29D 11/00, G02B 1/10, C23C 16/02**

(30) Priorität: **22.06.89 CH 2330/89**

(43) Veröffentlichungstag der Anmeldung:
**27.12.90 Patentblatt 90/52**

(84) Benannte Vertragsstaaten:
**DE ES FR GB IT**

(71) Anmelder: **Satis Vacuum AG**
**Forchstrasse 158**
**CH-8032 Zürich(CH)**

(72) Erfinder: **Ciparisso, Delio**
**Via Serodine 16**
**CH-6612 Ascona(CH)**

(74) Vertreter: **Petschner, Goetz**
**Patentanwaltsbüro G. Petschner**
**Seidengasse 18**
**CH-8001 Zürich(CH)**

(54) **Verfahren zur Vorbehandlung von zur Vakuumbeschichtung vorgesehenen durchsichtigen Kunststoffsubstraten und Einrichtung zur Durchführung des Verfahrens.**

(57) Die Vakuum-Einrichtung umfasst eine, an eine Vakuum-Pumpe (6) und an eine Gasquelle (11) anschliessbare, der Aufnahme von Haltermittel (5) für die Substrate (15) dienende Vakuum-Kammer (4), deren Innenraum von hochfrequenten Schwingungen zwischen den Elektroden (3) eines Hochfrequenz-Generators (1) durchsetzbar ist.

Durch eine solche Plasmabehandlung der Substrate wird eine Veränderung deren Oberfläche erreicht, derart, dass sich die nachfolgende Schicht mit einer bisher nicht erreichten Haftfestigkeit aufbringen lässt.

FIG. 1

FIG. 2

EP 0 403 985 A1

## Verfahren zur Vorbehandlung von zur Vakuumbeschichtung vorgesehenen durchsichtigen Kunststoffsubstraten und Einrichtung zur Durchführung des Verfahrens

Die vorliegende Erfindung betrifft ein Verfahren zur Vorbehandlung von zur Vakuumbeschichtung vorgesehenen durchsichtigen Kunststoffsubstraten, insbesondere optischen Gläsern.

Das Aufdampfen glasfremder Schichten aus den verschiedenartigsten Substanzen im Hochvakuum auf Kunststoffsubstrate, insbesondere optische Gläser, zur Erzeugung von Antireflexeigenschaften u.a. ist heute ständige Praxis.

Problematisch ist aber nach wie vor die Voraussetzung einer optimalen Vorbehandlung (Reinigung) der Substratoberfläche sowie der Zwischenschichten, um eine ausreichende Haftfestigkeit zu erhalten.

Ueblich ist, die von der Substratoberfläche oder Unterschicht adsorbierten mehrmolekularen Verunreinigungsbeläge aus Gas, Wasser oder anderen Verunreinigungen, welche die Haltbarkeit der Aufdampfschichten stark herabsetzen, durch Vorreinigung mit Ultraschall und im Vakuum durch Aufheizung zu beseitigen. Dies genügt nach den heutigen Anforderungen nicht.

Aufgabe der Erfindung ist deshalb die Schaffung eines Verfahrens zur Vorbehandlung von zur Vakuumbeschichtung vorgesehenen durchsichtigen Kunststoffsubstraten, insbesondere optischen Gläsern, das eine optimale Haftfestigkeit der auf die vorbehandelten Substrate aufgebrachten Antireflex-Schichten u. dgl. gewährleistet.

Dies wird nun erfindungsgemäss dadurch erreicht, dass die Substrate in einem Vakuum einem, durch Erhitzung eines Gases unter hochfrequenter Schwingungsenergie erzeugten Plasma ausgesetzt werden.

Es wurde gefunden, dass sich die Oberfläche der dem ionisierten Gas ausgesetzten Substrate derart verändert, dass sich die nachfolgende Schicht mit einer bisher nicht erreichten Haftfestigkeit aufbringen lässt.

Hierbei lässt sich die Plasmabehandlung nach jeder Beschichtungsphase wiederholen.

Vorteilhaft ist ferner, dass man bei genügend hoher Energiekonzentration extrem kurze Behandlungszeiten erreichen kann.

Es hat sich ferner gezeigt, dass die Ergebnisse weiter optimiert werden können, wenn die Gasmenge so dosiert wird, dass sich ein Druckgleichgewicht in der Vakuumkammer einstellt, das während der Plasmabehandlung konstant gehalten werden sollte. Als Gas kann hierbei Luft oder reaktives Gas oder nicht reaktives Gas oder Mischungen davon Anwendung finden.

Ferner betrifft die vorliegende Erfindung eine Einrichtung zur Durchführung des vorbeschriebenen Verfahrens, welche sich erfindungsgemäss auszeichnet durch eine, an eine Vakuum-Pumpe und an eine Gasquelle anschliessbare, der Aufnahme von Haltermittel für die Substrate dienende Vakuum-Kammer, deren Innenraum von hochfrequenten Schwingungen zwischen den Elektroden eines Hochfrequenz-Generators durchsetzbar ist.

Eine vorteilhafte Ausgestaltung dieser Einrichtung ergibt sich dabei, wenn zwischen Vakuum-Kammer und Gasquelle ein, von einem Vakuum-Messfühler ansteuerbares Dosierungs-Ventil angeordnet ist.

Hierbei ist es möglich, dass die Vakuum-Kammer aus Quarzglas besteht mit aussenseitig angeordneten Elektroden oder dass die Vakuum-Kammer aus Edelstahl besteht mit innenseitig angeordneten Elektroden.

Eine beispielsweise Ausführungsform des Erfindungsgegenstandes ist nachfolgend anhand der Zeichnung näher erläutert. Es zeigen:

Fig. 1 ein Prinzip-Schema der erfindungsgemässen Vakuum-Einrichtung mit Evakuierungs- und Begasungs-Mittel; und

Fig. 2 ein Prinzip-Schema der Vakuum-Einrichtung gemäss Fig: 1 mit den Hochfrequenzmitteln zur Plasma-Erzeugung.

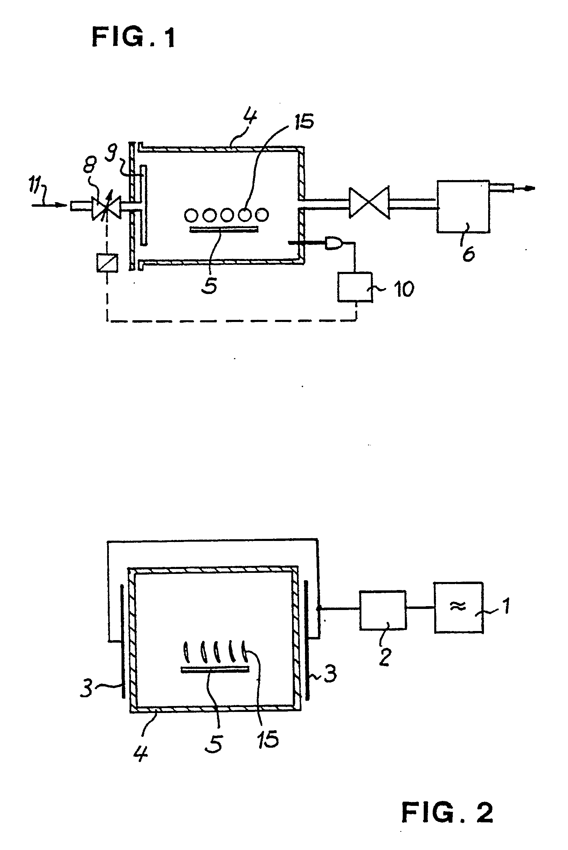

Die in den Fig. 1 und 2 veranschaulichte Einrichtung zur Vorbehandlung von zur Vakuumbeschichtung vorgesehenen durchsichtigen Kunststoffsubstraten, insbesondere optischen Gläsern 15, umfasst eine an eine Vakuum-Pumpe 6 und an eine Gasquelle 11 anschliessbare, der Aufnahme von Haltermittel 5 für die Substrate 15 dienende Vakuum-Kammer 4, deren Innenraum von hochfrequenten Schwingungen zwischen den Elektroden 3 eines Hochfrequenz-Generators 1 durchsetzbar ist.

Damit können die Substrate in einem Vakuum einem, durch Erhitzung eines Gases unter hochfrequenter Schwingungsenergie erzeugten Plasma ausgesetzt werden, um deren Oberfläche für eine optimal haftfeste Beschichtung geeignet zu machen.

Es hat sich dabei als vorteilhaft gezeigt, wenn die Gasmenge so dosiert wird, dass sich ein Druckgleichgewicht in der Vakuumkammer einstellt und wenn das Druckgleichgewicht während der Plasmabehandlung der Substrate konstant gehalten wird.

Um dies zu erreichen, ist die Ausgestaltung der Vakuum-Einrichtung so, dass zwischen Vakuum-Kammer 4 und Gasquelle 11 ein, von einem Vakuum-Messfühler 10 ansteuerbares Dosierungs-Ventil 8 angeordnet ist.

Das Gas wird dabei über eine sogenannte Gas-Dusche 9 in die Vakuum-Kammer 4 eingeleitet. Als Gas kann Luft oder reaktives Gas oder nicht reaktives Gas oder Mischungen davon Anwendung finden.

Wie Fig. 2 zeigt, ist der Hochfrequenz-Generator 1 mit den Elektroden 3 über ein geeignetes Anpassungs-Netzwerk 2 verbunden.

Ferner kann die Vakuum-Kammer 4 aus Quarzglas bestehen mit aussenseitig angeordneten Elektroden 3 (Fig.2) oder die Vakuum-Kammer kann aus Edelstahl bestehen mit innenseitig angeordneten Elektroden (nicht gezeigt).

## Ansprüche

1. Verfahren zur Vorbehandlung von zur Vakuumbeschichtung vorgesehenen durchsichtigen Kunststoffsubstraten, insbesondere optischen Gläsern, dadurch gekennzeichnet, dass die Substrate in einem Vakuum einem, durch Erhitzung eines Gases unter hochfrequenter Schwingungsenergie erzeugten Plasma ausgesetzt werden.

2. Verfahren nach Anspruch 1, dadurch gekennzeichnet, dass die Gasmenge so dosiert wird, dass sich ein Druckgleichgewicht in der Vakuumkammer einstellt.

3. Verfahren nach Anspruch 2, dadurch gekennzeichnet, dass das Druckgleichgewicht während der Plasmabehandlung der Substrate konstant gehalten wird.

4. Verfahren nach Anspruch 1, dadurch gekennzeichnet, dass als Gas Luft oder reaktives Gas oder nicht reaktives Gas oder Mischungen davon Anwendung findet.

5. Einrichtung zur Durchführung des Verfahrens nach Anspruch 1, gekennzeichnet durch eine, an eine Vakuum-Pumpe (6) und an eine Gasquelle (11) anschliessbare, der Aufnahme von Haltermittel (5) für die Substrate (15) dienende Vakuum-Kammer (4), deren Innenraum von hochfrequenten Schwingungen zwischen den Elektroden (3) eines Hochfrequenz-Generators (1) durchsetzbar ist.

6. Einrichtung nach Anspruch 5, dadurch gekennzeichnet, dass zwischen Vakuum-Kammer (4) und Gasquelle (11) ein, von einem Vakuum-Messfühler (10) ansteuerbares Dosierungs-Ventil (8) angeordnet ist.

7. Einrichtung nach Anspruch 5, dadurch gekennzeichnet, dass die Vakuum-Kammer (4) aus Quarzglas besteht mit aussenseitig angeordneten Elektroden (3).

8. Einrichtung nach Anspruch 5, dadurch gekennzeichnet, dass die Vakuum-Kammer (4) aus Edelstahl besteht mit innenseitig angeordneten Elektroden (3).

## FIG . 1

## FIG . 2

Europäisches Patentamt

# EUROPÄISCHER RECHERCHENBERICHT

Nummer der Anmeldung

EP 90 11 1377

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| X | NASA - Technical Brief, Nr. NTN-77/0852, 1976, Washington, US "Antireflection coating for plastic lenses" * Absatz 3; Figur * --- | 1, 4, 5, 8 | H01J37/32 B29D11/00 G02B1/10 C23C16/02 |
| X | US-A-4096315 (KUBACKI) * Spalte 2, Zeilen 46 - 50; Figur * * Spalte 3, Zeile 30 - Spalte 4, Zeile 60 * --- | 1, 2, 4, 5, 8 | |
| X | PATENT ABSTRACTS OF JAPAN vol. 11, no. 107 (P-563)(2554) 04 April 1987, & JP-A-61 255301 (JAPAN SYNTHETIC RUBBER CO LTD) 13 November 1986, * das ganze Dokument * --- | 1, 5, 7, 8 | |
| A | PATENT ABSTRACTS OF JAPAN vol. 9, no. 143 (E-322)(1866) 18 Juni 1985, & JP-A-60 025232 (HITACHI SEISAKUSHO K.K.) 08 Februar 1985, * das ganze Dokument * ----- | 2, 3, 6 | |

| | RECHERCHIERTE SACHGEBIETE (Int. Cl.5 ) |
|---|---|
| | H01J B29D G02B C23C |

Der vorliegende Recherchenbericht wurde für alle Patentansprüche erstellt

| Recherchenort | Abschlußdatum der Recherche | Prüfer |
|---|---|---|
| DEN HAAG | 01 OKTOBER 1990 | SCHAUB G.G. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
..............................................................................
& : Mitglied der gleichen Patentfamilie, übereinstimmendes Dokument

EPO FORM 1503 03.82 (P0403)